# FASCICULE DE BREVET EUROPEEN

(11) **EP 1 743 513 B1**
(45) Date de publication et mention de la délivrance du brevet: **03.10.2007**
(21) Numéro de dépôt: 05732610.0
(22) Date de dépôt: 14.04.2005
(51) Int. Cl.: H05K 7/20

(54) **SUPPORT ADAPTE POUR RECEVOIR UN MODULE ELECTRONIQUE A CIRCUIT DE REFROIDISSEMENT PAR LIQUIDE, ET ENSEMBLE FORME PAR SUPPORT ET MODULES**
HALTERUNG ZUR AUFNAHME EINES ELEKTRONISCHEN MODULS, DAS MIT EINEM FLÜSSIGKEITSKÜHLKREIS AUSGESTATTET IST UND DER AUFBAU AUS BESAGTER HALTERUNG UND DEN MODULEN
SUPPORT FOR RECEIVING AN ELECTRONIC MODULE PROVIDED WITH A LIQUID COOLING CIRCUIT AND ASSEMBLY FORMED BY SAID SUPPORT AN MODULES

(30) Priorité: 23.04.2004 FR 0404372
(43) Date de publication de la demande: 17.01.2007
(73) Titulaire: Michelin Recherche et Technique S.A., 1763 Granges-Paccot (CH)
(72) Inventeur: GOBET, Alain, CH-1746 Prez-Vers-Noreaz (CH); LAURENT, Daniel, CH-1723 Marly (CH)
(74) Mandataire: Bauvir, Jacques
(86) Numéro de dépôt international: PCT/EP2005/003944
(87) Numéro de publication internationale: WO 2005/104643

(56) Documents cités:
- EP-A- 0 353 762
- US-A- 5 633 786
- US-A1- 2002 127 900
- REMSBURG R: "QUICK DISCONNECTS FOR ELECTRONIC COOLING" MACHINE DESIGN, PENTON/IPC, CLEVELAND, US, vol. 61, no. 6, 23 mars 1989 (1989-03-23), pages 73-76, XP000052862 ISSN: 0024-9114

## Description

### DOMAINE DE L'INVENTION

L'invention est relative au domaine de l'électronique, plus particulièrement à la construction de modules électroniques, notamment à la construction de modules électroniques bien adaptés aux véhicules automobiles.

### ETAT DE LA TECHNIQUE

Il se dessine à l'heure actuelle une tendance nette à utiliser des actuateurs électriques pour un nombre sans cesse plus grand de fonctions implantées dans les véhicules automobiles. Cette tendance, déjà ancienne pour de nombreuses fonctions de confort ou pour des fonctions périphériques des moteurs à combustion interne ou des boîtes de vitesse, concerne maintenant de plus en plus des fonctions de base des véhicules, comme la suspension, la direction, les freins et la motorisation. Les progrès de l'électronique permettent en effet un pilotage toujours plus efficace de différentes fonctions. Il en résulte que la plupart des actuateurs des véhicules automobiles, sinon tous, seront dans le futur des organes électriques. Un avantage des actuateurs purement électriques est qu'ils se marient mieux que les actuateurs hydrauliques ou électro-hydrauliques avec un pilotage tenant compte de nombreux paramètres traités par calcul au moyen de logiciels sophistiqués.

Pour illustrer cette évolution dans le monde de l'automobile, citons par exemple les véhicules hybrides, en particulier les véhicules hybrides série dans lesquels, on le sait, la propulsion ne se fait que via un ou des moteurs électriques. Ces véhicules sont équipés de dispositifs de génération d'énergie électrique comportant un moteur à combustion interne entraînant un alternateur, et de dispositifs de propulsion électrique des roues, bien souvent un moteur électrique par roue motrice.

D'autres exemples d'application récente d'actuateurs électriques sont donnés par les véhicules pourvus d'actionneurs électriques fonctionnant en parallèle d'un ressort pour assurer un contrôle actif de la suspension ainsi que des fonctions d'anti-roulis et d'anti-tangage du véhicule. Citons encore les systèmes de direction électrique permettant par exemple un braquage individualisé de chacune des quatre roues sans liaison mécanique entre le dispositif de commande à disposition du conducteur (volant par exemple) et la roue. Citons encore les systèmes de contrôle actif du roulis de l'habitacle et/ou du carrossage des roues.

Certaines de ces fonctions, principalement la traction d'un véhicule, mettent en jeu des puissances considérables. Le pilotage électronique implique donc l'emploi de composants de puissances. Même si le rendement des différents éléments utilisés est bon, il y a quand même inéluctablement des pertes et toute perte énergétique provoque nécessairement, s'agissant d'organes de puissance, des dégagements de calories significatifs. On trouve par exemple dans les véhicules décrits ci-dessus des modules électroniques mettant en oeuvre des puissances de l'ordre de quelques Kilowatts jusqu'à plusieurs dizaines de Kilowatts. C'est par exemple le cas des onduleurs destinés à piloter des moteurs électriques. C'est par exemple aussi le cas des modules électroniques destinés à la génération d'une alimentation stabilisée de puissance électrique. Ce sont dans tous les cas des convertisseurs de puissance dimensionnés pour gérer des puissances importantes.

Ces modules électroniques reçoivent en général en entrée des alimentations à des niveaux de tension élevés (pouvant atteindre plusieurs centaines de volts) et de courant élevés (plusieurs centaines d'ampères). Ils génèrent en sortie à leur tour des niveaux de tension élevés (plusieurs centaines de volts) et de courant élevés (plusieurs centaines d'ampères), par exemple destinés à alimenter des moteurs électriques de traction de type synchrone auto-pilotés à aimants permanents.

Ces convertisseurs de puissance comportent en général des composants électroniques de puissance, par exemple des transistors de type IGBT ou MOSFETS. Ces composants, dans leur fonctionnement, ont des pertes qui provoquent un échauffement. Même s'il est souhaitable de travailler avec des composants présentant le minimum de pertes (ce qui améliore le rendement des modules considérés), il faut être capable d'évacuer les calories inéluctablement dissipées. En outre, la recherche d'encombrements réduits est plus particulièrement désirable dans le cas d'une implantation de ces convertisseurs dans des véhicules. Ceci amène à préférer un mode de refroidissement par fluide liquide, par exemple un mélange d'eau et de glycol.

Se pose alors le problème de pouvoir installer et extraire du véhicule aussi rapidement que possible ces convertisseurs de puissance. En effet, les manipulations nécessaires pour brancher et débrancher de nombreux raccordements électriques et hydrauliques deviennent vite fastidieuses. En outre, ces opérations sont toujours sources potentielles d'erreurs, voire de casse, et donc dégradent par elles-mêmes la fiabilité. D'autre part, la rapidité de montage et d'intervention est importante, tant dans le cas de la construction des véhicules que dans le cas de leur maintenance.

Remarquons encore que, si le module électronique est incorporé à un circuit de refroidissement à fluide caloporteur liquide, le circuit comprend notamment une pompe de circulation du liquide. Le circuit de refroidissement est en général commun pour plusieurs modules électroniques. Les opérations de montage et démontage évoquées ci-dessus doivent prendre en compte le temps nécessaire à interrompre et à rétablir aussi le circuit de refroidissement.

Dans le domaine automobile, le brevet US 5,633,784 propose d'intégrer sur un même support les canalisations hydrauliques et les liaisons électriques nécessaires. Le connecteur électrique proposé est d'une conception particulière offrant une seule voie de connexion électrique et est assez encombrant. Dans le domaine des appareils électriques, on connaît par le brevet US 6,616,469 un dispositif pour connecter hydrauliquement un circuit de refroidissement aménagé sur une carte électrique, les connexions hydrauliques étant pourvues de clapets auto-obturants. Aucune de ces solutions n'est pleinement satisfaisante car aucune ne permet, en un seul mouvement de rapprochement relatif, de réaliser tout à la fois les connexions hydrauliques et électriques de grande fiabilité notamment offrant une grande qualité des contacts électriques pour les signaux faibles, y compris après de nombreuses manoeuvres, y compris lorsqu'il n'est pas possible d'assurer un pré-positionnement précis.

### BREVE DESCRIPTION DE L'INVENTION

L'objectif de l'invention est de proposer une solution facilitant le montage et le démontage de sous-ensembles comprenant des composants électroniques de puissance, bien adaptée pour former un équipement pour véhicule automobile, mais pouvant aussi trouver des applications pratiques dans des machines industrielles notamment.

L'invention concerne une conception d'ensemble pour un support d'un ou de plusieurs modules électroniques adaptés l'un à l'autre ou l'un aux autres.

L'invention propose un ensemble formé par au moins un module électronique et un support formant au moins une base sur laquelle le module électronique peut être emboîté de façon à positionner ledit au moins un module sur le support et établir des connections électriques nécessaires entre au moins une paire de connecteurs électriques l'un des connecteurs électriques étant monté sur le module et l'autre des connecteurs électriques étant monté sur le support, ledit au moins un module comportant un circuit pour fluide caloporteur, ledit circuit ayant une entrée et une sortie pour le fluide caloporteur, le support comportant au moins un orifice d'apport pour alimenter ledit au moins un module en fluide caloporteur et au moins un orifice de collecte pour recueillir le fluide caloporteur, le support et le module comportant chacun au moins deux raccords hydrauliques pour assurer le raccordement du circuit aux orifices, l'ensemble étant caractérisé en ce que pour chaque paire de connecteurs électriques, l'un des connecteurs électriques est monté par des moyens de montage laissant le connecteur flottant dans le plan perpendiculaire au mouvement de rapprochement relatif entre module et base.

L'invention s'étend aussi au support en lui-même, formant au moins une base sur laquelle au moins un module électronique peut être emboîté de façon à positionner ledit au moins un module sur le support, le support comportant au moins une embase pour recevoir au moins un connecteur électrique destiné à assurer une connexion électrique vers ledit au moins un module, ladite embase définissant un plan de montage pour ledit connecteur électrique, le support comportant au moins un orifice d'apport pour alimenter ledit au moins un module en fluide caloporteur et au moins un orifice de collecte pour recueillir le fluide caloporteur, le support comportant au moins un raccord hydraulique sur chacune des orifices, chacun des raccords hydrauliques étant agencé de façon à ce que le raccordement hydraulique se fasse dans une direction sensiblement perpendiculaire audit plan de montage, caractérisé en ce que ledit au moins un connecteur électrique est monté par des moyens de montage laissant le connecteur flottant dans le plan de la base.

L'invention utilise des moyens de montage mécaniques de modules sur un support et un système de raccordements du module électronique par connecteurs électriques et hydrauliques, le tout requérant aussi peu de manipulations que possible. Notamment, l'invention dispense de devoir prépositionner module et support. La solution selon l'invention offre donc des modules électroniques enfichables, et immédiatement prêts à fonctionner, sans qu'il soit nécessaire de purger le circuit hydraulique.

### BREVE DESCPRITION DES FIGURES

La suite de la description permet de bien faire comprendre tous les aspects de l'invention en s'appuyant sur les dessins joints.
La figure 1 est une perspective montrant un support et plusieurs modules électroniques, formant un ensemble selon l'invention ;
La figure 2 montre le même support selon l'invention, vu en perspective et débarrassé de tous les modules ;
La figure 3 est une autre perspective montrant plus particulièrement la face d'un premier module selon l'invention destinée à coopérer avec le support visible aux figures 1 et 2 ;
La figure 4 est une autre perspective montrant plus particulièrement la face d'un deuxième module selon l'invention destinée à coopérer avec le même support ;
La figure 5 est une autre perspective montrant plus particulièrement la face d'un troisième module selon l'invention destinée à coopérer avec le même support ;
La figure 6 est une autre perspective montrant plus particulièrement la face d'un quatrième module selon l'invention destinée à coopérer avec le même support;
Les figures 7 et 8 illustrent le montage d'un module particulier sur le support ;

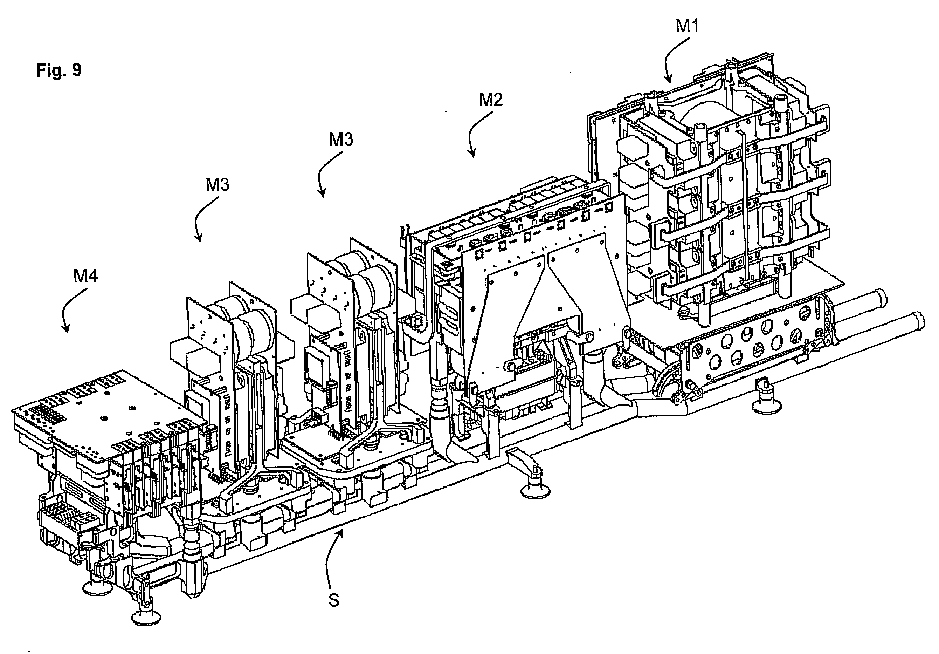

La figure 9 est une perspective montrant les mêmes modules électroniques montés sur le même support, prêts à fonctionner.

### DESCRIPTION DU MEILLEUR MODE DE REALISATION DE L'INVENTION

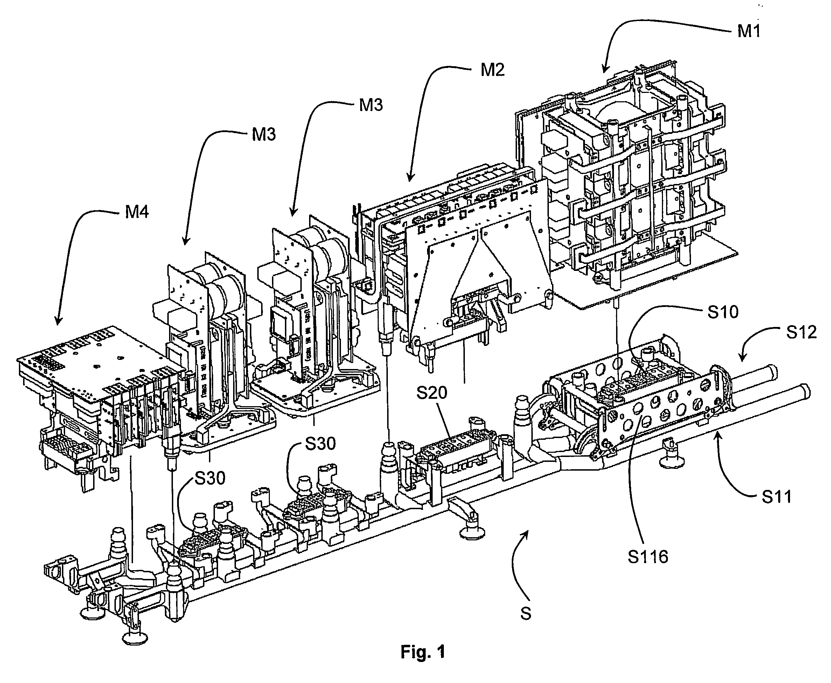

A la figure 1, pour bien faire comprendre le montage, on voit un support S destiné à recevoir plusieurs modules électroniques tel que les modules M1, M2, M3 et M4. Chaque module électronique est représenté éloigné du support S mais en regard chacun de la position qu'il occupera après montage. Le support S illustrant l'invention est conçu pour recevoir cinq modules, dont deux identiques. Il est conçu pour se loger en position transversale par exemple derrière une banquette arrière dans une berline de tourisme, ou en position longitudinale dans une console centrale d'un véhicule de tourisme.

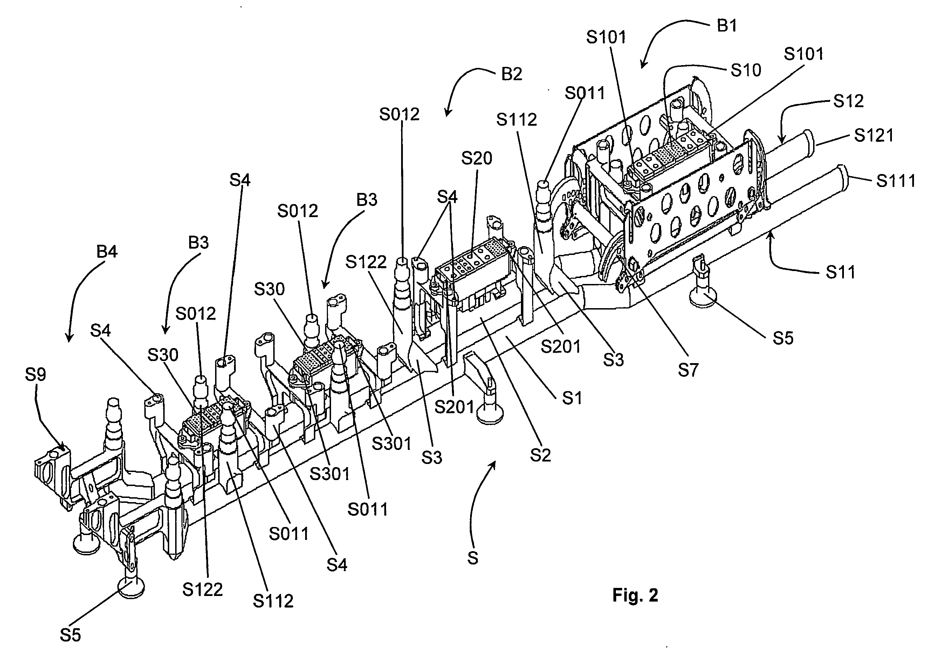

Passons tout d'abord à la description du support, pour laquelle le lecteur est renvoyé plus particulièrement à la figure 2. Le support S comporte une structure mécanique porteuse réalisée de façon monobloc, par exemple en tubes métalliques conformés et assemblés de façon appropriée. Le support S joue en même temps un rôle électrique en assurant la mise à la masse de tous les éléments.

La structure mécanique porteuse est essentiellement composée par des tubes sensiblement parallèles S1 et S2. Ces tubes S1 et S2 sont destinés à permettre la circulation d'un liquide caloporteur. Dans l'illustration, ces tubes S1 et S2 ont l'allure générale d'une droite mais contiennent toutefois quelques coudes. Par sensiblement parallèles, on vise le développement des tubes dans l'espace, c'est à dire le tracé suivi par les tubes dans l'espace, mais on n'a pas voulu donner une importance quelconque à une allure qui serait strictement droite. L'allure générale est seulement dictée par le volume disponible pour l'installation du support et des modules, par exemple à l'intérieur du véhicule automobile pour une application de l'invention aux équipements électriques pour véhicules automobiles. L'allure générale n'est en aucune manière dictée par des considérations fonctionnelles propres aux modules ou au support. En revanche, les considérations fonctionnelles dictent qu'il y ait bien entendu aussi peu de perte de charge que possible à l'intérieur des tubes S1 et S2, ce qui conduit à préférer les coudes de grand rayon aux coudes de petits rayons, ce qui conduit à n'admettre que des changements de direction formant un angle relatif aussi faible que possible, etc....

Les tubes S1 et S2 sont reliés mécaniquement et sans communication hydraulique d'un tube à l'autre par des entretoises S3, de façon à ce que leur assemblage forme ainsi une pièce mécanique monobloc. La structure mécanique porteuse, c'est à dire le support S, comporte au moins un pied S5 et typiquement au moins trois pieds S5, par lesquels le support S est rendu solidaire de la caisse du véhicule.

Chacun des tubes S1 et S2 forme de préférence une rampe commune S11 et S12 à partir de laquelle le liquide caloporteur est distribué vers chaque base, pour être introduit en parallèle dans les différents modules électroniques M1, M2, M3, M4, etc.... A cette fin, chacun des tubes aboutit d'un seul côté à une extrémité formant orifice S111 et S121 respectivement, pour être branché sur le véhicule à une installation dans laquelle circule un liquide caloporteur. L'installation comporte, comme bien connu en soi, pompe, radiateur, éventuellement thermostat, canalisation, etc..... Au moins deux canalisations S112 et S 122 par module électronique sont prévues et chacune est branchée (raccordement hydraulique) en dérivation sur un tube différent. Les canalisations S112 et S 122 font partie de la pièce mécanique monobloc.

Le support comporte au moins un orifice d'apport pour alimenter ledit au moins un module en fluide caloporteur et au moins un orifice de collecte pour recueillir le fluide caloporteur, les modules électroniques (M1, M2, M3, M4) étant alimentés en fluide caloporteur en parallèle. Chaque orifice d'apport et chaque orifice de collecte de chaque canalisation S112, S122 aboutit respectivement à l'un des raccords hydrauliques S011 et S012. Remarquons que certaines des entretoises S3 peuvent elles-mêmes être des tubes assurant le raccordement hydraulique entre l'un tube des S1 ou S2 et les canalisations S 112, respectivement S122 mais dans ce cas, bien entendu, l'entretoise ne débouche pas dans l'autre des tubes. Bien entendu, l'alimentation hydraulique en parallèles des modules n'est pas impérative, l'invention couvrant aussi bien un branchement en série des circuits hydrauliques internes aux modules électriques, ou certains d'entre eux au moins.

Etant donné le poids des modules électroniques, en général, la liaison de ceux-ci au support par les raccordements hydrauliques peut ne pas être suffisante pour assurer la stabilité mécanique. Dès lors, de préférence, on prévoit des dispositifs supplémentaires dédiés à la fixation mécanique. C'est ainsi que, de préférence, le support est pourvu d'au moins une patte S4 par module électronique (servant de liaison électrique à la masse), ladite au moins une patte étant reliée mécaniquement et sans communication hydraulique à l'un ou l'autre des tubes S1, S2 ou aux deux. Cela permet de prévoir sur les modules des pions de guidage qui permettent d'aligner les raccordements hydrauliques et électriques avant que ces derniers n'entrent en contact l'un avec l'autre. Ceci aide à effectuer un bon prépositionnement de chaque module par rapport au support.

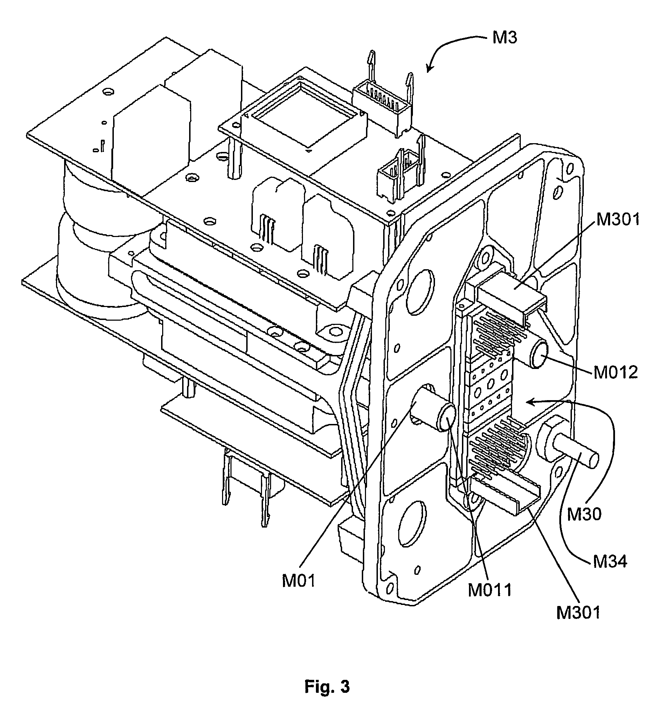

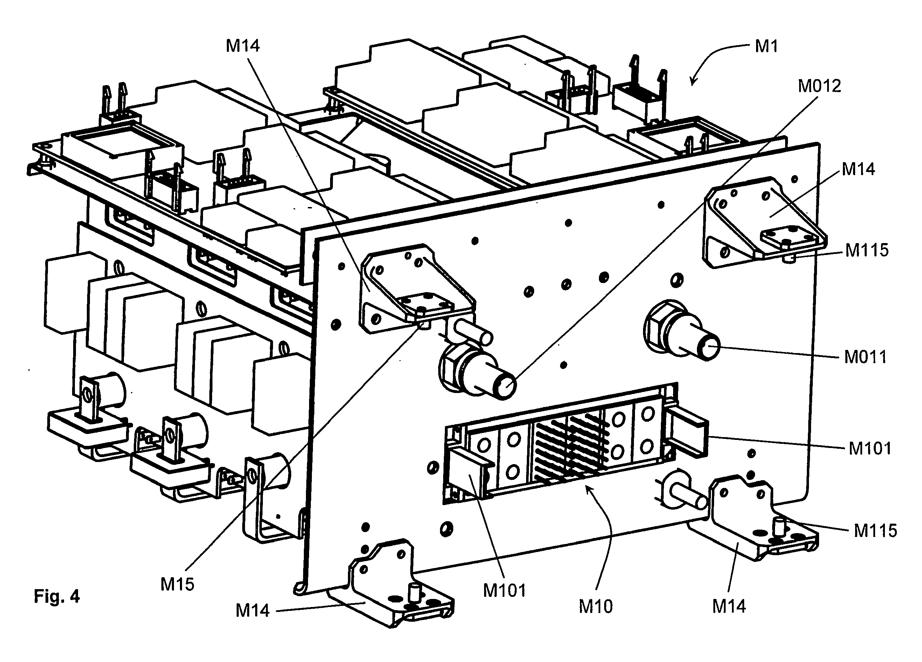

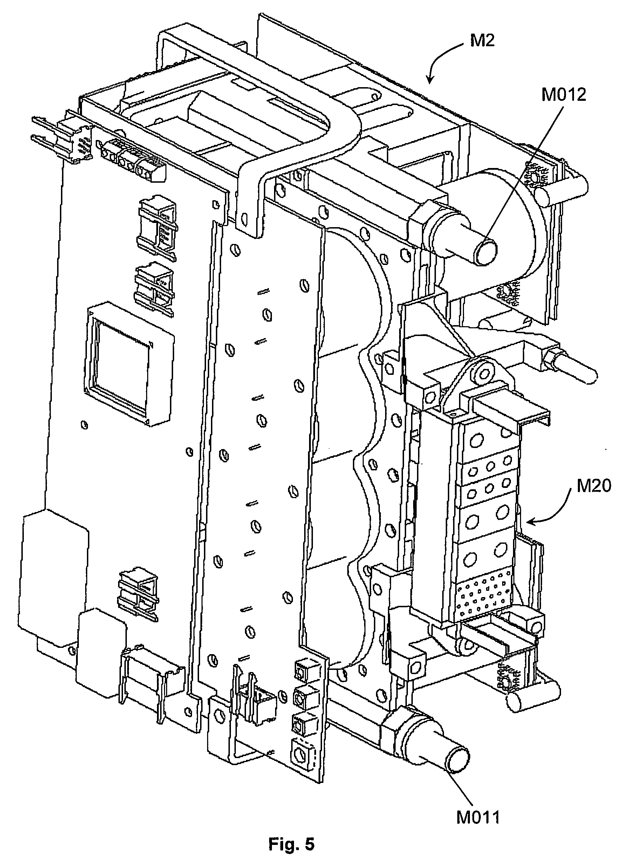

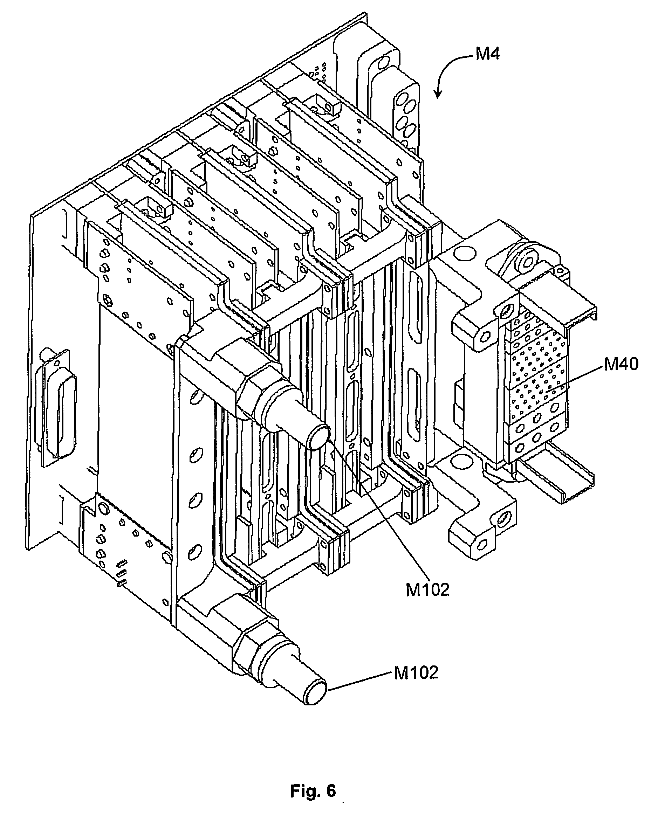

Le support comporte des éléments de connexion électrique. Sur le support, on voit un certain nombre de connecteurs électriques S10, S20, S30, en pratique au moins un par module électronique. Ainsi, sur le support S, les connecteurs électriques, raccords hydrauliques et pattes de maintien mécanique constituent ensemble autant de base qu'il y a de module électronique à monter. A la figure 2, on a repéré les bases B1, B2, B3 (deux bases B3), B4 destinées chacune à recevoir un module électronique tel que les modules M1 (figures 4, 7 et 8), M2 (figure 5), M3 (figure 3) et M4 (figure 6).

Les connecteurs électriques sont reliés mécaniquement à ladite structure mécanique porteuse réalisée de façon monobloc, pièce mécanique principale du support. A l'extrémité gauche de la figure 2, on voit deux des nombreuses embases S9 nécessaires au montage des connecteurs électriques. Les embases destinées à recevoir un connecteur définissent un plan de montage pour recevoir ledit connecteur électrique. En consultant la figure 1, on comprend que les connecteurs électriques S10, S20, S30, ..., tout comme les raccords hydrauliques S011 et S012 d'ailleurs, sont conçus et montés pour que tous les raccordements, aussi bien électriques qu'hydrauliques, se fassent par un mouvement orienté dans une direction sensiblement perpendiculaire au plan de montage défini sur le support par les embases S9.

Dans le mode préféré de réalisation de l'invention choisi pour la présente illustration, chacun des connecteurs électriques S10, S20, S30, permet d'acheminer l'ensemble des signaux électriques. Chaque connecteur électrique regroupe des connexions de puissance (alimentation principale du module, onduleur d'un module destiné à piloter un moteur électrique de traction, ...), ainsi que des connexions de mesure (position moteur,...). En ce qui concerne les connexions de puissance, il existe donc pour le ou les connecteurs électriques concernés au moins un plot de contact à section de contact supérieure à 6 mm² pour le passage de courants de forte intensité. Chaque connecteur est bien entendu relié à un faisceau électrique, non représenté pour ne pas surcharger les dessins, le ou les faisceaux électriques étant reliés par ailleurs aux actuateurs ou autres organes appropriés sur le véhicule, éventuellement via d'autres connecteurs.

L'un des connecteurs électriques de chaque paire de connecteurs électriques associés, par exemple les connecteurs électriques S10, S20, S30, ... montés sur le support (mais l'inverse est bien entendu possible), est monté par des moyens de montage laissant le connecteur flottant dans le plan perpendiculaire au mouvement de rapprochement relatif entre module et base. Ceci aide à ce que les contacts électriques ne soient pas sollicités par des contraintes mécaniques parasites, provenant de défauts d'alignement, de tolérances de fabrications, etc. .....

Avantageusement, chaque connecteur électrique S10, S20, S30, ... comporte des guides S101, S201, S301, ... qui permettent d'aligner des tiges de guidage de chaque connecteur électrique S10, S20, S30, ... avec le connecteur électrique associé M10, M20, M30, M40 sur les modules (voir infra), avant que les contacts électriques mâles et femelles ne se rencontrent. Ceci garantit que le guidage n'est réalisé en aucun cas par les contacts électriques. Par cette mesure additionnelle, on augment la durée de vie des contacts et on peut éviter de les dimensionner mécaniquement pour ce genre de sollicitations.

Passons à la description des modules électroniques M1 (voir figure 4, 7 et 8), M2 (voir figure 4), M3 (voir figure 5), M4 (voir figure 6). Mêmes si leurs fonctions électriques peuvent être très différentes et donc leurs composants électroniques très différents, l'invention se rapporte aux aspects mécaniques de la connexion électrique et au refroidissement par liquide hydraulique, qui sont tous communs aux différents modules. Il suffit donc de décrire plus en détail un seul de ces modules, par exemple le module M3.

La figure 3 montre la face du module électronique M3 destinée à coopérer avec la base prévue sur le support S pour recevoir ce module électronique. De préférence, le ou lesdits modules et le support sont agencés pour établir des connections électriques et hydrauliques nécessaires par un seul mouvement de rapprochement relatif entre module et support. On voit plus particulièrement un connecteur électrique M30, ses tiges de guidage M301, un circuit M01 pour fluide caloporteur, deux raccords hydrauliques M011 et M012 pour assurer le raccordement du circuit M01 sur le support. Pour pouvoir extraire chacun des modules électroniques du véhicule sans purger le circuit de refroidissement, les raccords hydrauliques M011 (et S01 1 sur le support) et M012 (ainsi que S012 sur le support) sont de préférence auto-obturants. Ainsi, chaque module électrique peut être préchargé en fluide de refroidissement et purgé à l'avance, les purgeurs éventuellement utiles pouvant même être extérieurs aux modules. Les modules peuvent être ainsi véritablement prêts à l'emploi.

De préférence, les raccords hydrauliques M011 (et S011 sur le support) et M012 (ainsi que S012 sur le support) sont agencés pour pouvoir être accouplés par le seul mouvement de rapprochement relatif entre module et support. Le module électronique M3 comporte un système de guidage mécanique représenté par les pions de centrage M34, qui ont aussi une fonction électrique, à savoir la mise à la masse.

Passons à la description du montage des modules électroniques sur le support.

Traitons d'abord le cas du module M3 (figure 3). La première étape consiste à insérer les pions M34 dans les pattes S4 du support S. En même temps, on insère les tiges de guidage M301 du connecteur électrique S30 dans les guides S301 du support S. Ensuite, par simple enfoncement du module M3 en direction du support S, on provoque les raccordements hydrauliques et les connexions électriques.

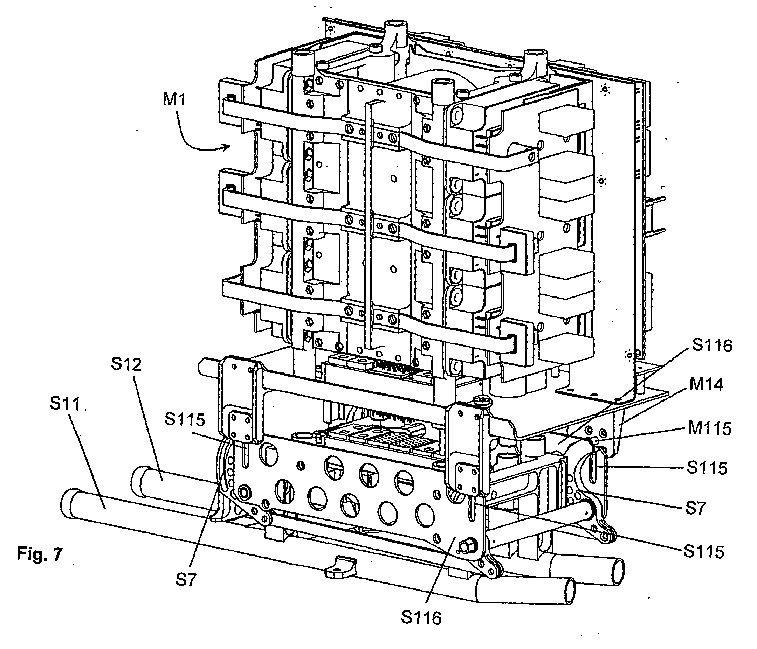

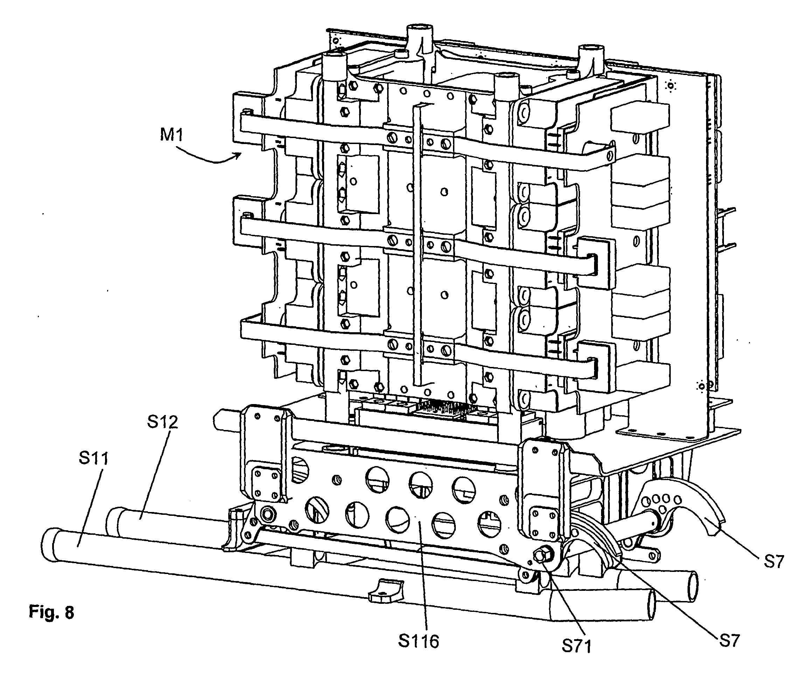

Avantageusement, on peut en outre prévoir au moins pour certains modules un mécanisme de rapprochement relatif d'un module vers le support. Le module M1 visible à la figure 4 est adapté pour un tel mécanisme, qui dans ce cas particulier est partie intégrante du support S. Par exemple, le module M1 est équipé d'ergots M115 agencés sur des piétements M14. Les ergots M115 sont destinés à être insérés dans des lumières S115 prévues sur des flasques S116 rigidement liés au support S (voir figures 7 et 8). Quatre cames S7 rotatives sont montées sur les flasques S116. Une tête de commande S71 permet la rotation simultanée des quatre cames S7, qui entraînent les ergots M115 vers le support, ce qui enfonce le module électronique M1 sur sa base B1 tout en provoquant la connexion électrique et le raccordement hydraulique.

De préférence, chaque module est immobilisé sur le support par un mécanisme de verrouillage approprié. Le mécanisme de rapprochement relatif décrit ci-dessus joue également ce rôle.

Bien entendu, cette disposition de construction peut s'appliquer à d'autres domaines que les véhicules, à savoir les trains, avions, ou machines industrielles, à tous les cas où l'on recherche un faible encombrement, où la quantité de calories à dissiper est importante, où l'on recherche une grande de rapidité de mise en place, de dépannage, etc.

## Revendications

1. Ensemble formé par plusieurs modules électroniques (M1, M2, M3, M4) et un support (S) comportant plusieurs bases, chacune pouvant recevoir un module électronique de façon à positionner lesdits modules sur le support et établir des connections électriques nécessaires entre au moins une paire de connecteurs électriques (M10 et S 10, M20 et S20, M30 et S30, M40 et S40), l'un des connecteurs électriques de chaque paire étant monté sur le module et l'autre des connecteurs électriques de chaque paire étant monté sur le support, l'un des connecteurs électriques de chaque paire (S10, S20, S30, S40) étant monté par des moyens de montage laissant le connecteur flottant dans le plan perpendiculaire au mouvement de rapprochement relatif entre module et base, chaque module comportant un circuit (M01) pour fluide caloporteur, ledit circuit ayant une entrée et une sortie pour le fluide caloporteur, le support comportant, par module, au moins un orifice d'apport pour alimenter ledit au moins un module en fluide caloporteur et au moins un orifice de collecte pour recueillir le fluide caloporteur, chaque module comportant au moins deux raccords hydrauliques (M011 et M012) pour assurer le raccordement du circuit aux orifices, le support comportant une rampe d'entrée formant rampe commune d'entrée (S 11) pour toutes les bases et comportant au moins un raccord hydraulique (S0 11) par base, et une rampe de sortie formant rampe commune de sortie (S 12) pour toutes les bases et comportant au moins un raccord hydraulique (S012) par base, de sorte que le ou les modules électroniques (M1, M2, M3, M4) sont agencés pour être alimentés en fluide caloporteur en parallèle.

2. Ensemble selon la revendication 1, dans lequel lesdits raccords sont auto-obturants et agencés de façon à pouvoir être accouplées par le seul mouvement de rapprochement relatif entre module et support.

3. Ensemble selon la revendication 1 ou 2 dans lequel le support comporte une structure mécanique porteuse monobloc, lesdites rampes étant intégrées dans ladite structure porteuse.

4. Ensemble selon l'une des revendications 1 à 3, dans lequel le support comporte une structure mécanique porteuse monobloc, la structure mécanique porteuse comportant des tubes sensiblement parallèles (S1, S2) formant chacun l'une des rampes communes, les tubes étant reliés mécaniquement et sans communication hydraulique d'un tube à l'autre par des entretoises (S3), au moins deux canalisations (S112 et S 122) par base étant branchées en dérivation chacune sur un tube différent, chaque canalisation aboutissant à l'un des raccords hydrauliques.

5. Ensemble selon l'une des revendications 1 à 4 dans lequel le support comporte au moins une patte (S4) par base, ladite au moins une patte par base étant reliée mécaniquement et sans communication hydraulique à l'un ou l'autre des tubes ou aux deux.

6. Ensemble selon la revendication 5, dans lequel la structure mécanique porteuse monobloc comporte au moins un pied de fixation (S5).

7. Ensemble selon l'une des revendications 1 à 6 dans lequel chacune des rampes comportant un orifice (S111, S121) destiné à être raccordé à une installation extérieure dans laquelle circule le fluide caloporteur.

8. Ensemble selon l'une des revendications 1 à 7, comprenant un mécanisme de verrouillage d'un module sur le support.

9. Ensemble selon la revendication 8, comprenant un mécanisme de rapprochement (S7) relatif du module vers le support.

10. Ensemble selon l'une des revendications 1 à 9, dans lequel le support comporte au moins une embase (S9) pour recevoir un connecteur électrique.

11. Ensemble selon l'une quelconque des revendications 1 à 10, formant un équipement pour véhicule automobile.

12. Ensemble selon l'une quelconque des revendications 1 à 11, dans lequel ledit module comprend des composants électroniques de puissance.

13. Ensemble selon l'une quelconque des revendications 1 à 12, dans lequel ledit module comprend un onduleur destiner à piloter un moteur électrique de traction.

14. Support (S) formant plusieurs bases (B1, B2, B3, B4) destinées chacune à recevoir un module électronique, le support comportant plusieurs embases (S9) pour recevoir chacune au moins un connecteur électrique (S 10, S20, S30, S40) destiné à assurer une connexion électrique vers l'une des modules, ladite embase définissant un plan de montage pour chaque connecteur électrique, au moins un connecteur électrique (S10, S20, S30, S40) étant monté par des moyens de montage laissant le connecteur flottant dans le plan de la base, le support comportant au moins un orifice d'apport pour alimenter lesdits modules en fluide caloporteur et au moins un orifice de collecte pour recueillir le fluide caloporteur, le support comportant une rampe d'entrée formant rampe commune d'entrée (S11) pour toutes les bases et comportant une rampe de sortie formant rampe commune de sortie (S 12) pour toutes les bases, le support comportant au moins un raccord hydraulique (S011, S0112) sur chacune des orifices, chacun des raccords hydrauliques étant agencé de façon à ce que le raccordement hydraulique se fasse dans une direction sensiblement perpendiculaire audit plan de montage, de sorte que le ou les modules électroniques (M1, M2, M3, M4) puissent être alimentés en fluide caloporteur en parallèle.

15. Support selon la revendication 14, dans lequel ledit raccord est auto-obturant.

16. Support selon la revendication 14 ou 15, ayant une structure mécanique porteuse monobloc, lesdites rampes étant intégrées dans ladite structure porteuse.

17. Support selon la revendication 16, ayant une structure mécanique porteuse monobloc, la structure mécanique porteuse comportant des tubes sensiblement parallèles formant chacun l'une des rampes communes, les tubes étant reliés mécaniquement et sans communication hydraulique d'un tube à l'autre par des entretoises, au moins deux canalisations par base étant branchées en dérivation chacune sur un tube différent, chaque canalisation aboutissant à l'un des raccords hydrauliques.

18. Support selon l'une des revendications 14 à 17, comportant au moins une patte par base, ladite au moins une patte par base étant reliée mécaniquement et sans communication hydraulique à l'un ou l'autre des tubes ou aux deux.

19. Support selon la revendication 16, dans lequel la structure mécanique porteuse monobloc comporte au moins trois pieds de fixation.

20. Support selon l'une des revendications 14 à 19, dans lequel chacune des rampes comportant un orifice (S111, S121) destiné à être raccordé à une installation extérieure dans laquelle circule le fluide caloporteur.

21. Support selon l'une des revendications 14 à 20, comprenant un mécanisme de verrouillage d'un module sur le support.

22. Support selon la revendication 21, comprenant un mécanisme de rapprochement relatif du module vers le support.

## Claims

1. Assembly formed by a plurality of electronic modules (M1, M2, M3, M4) and a support (S) comprising a plurality of bases, each being able to receive an electronic module so as to position the said modules on the support and to make the necessary electrical connections between at least one pair of electrical connectors (M10 and S10, M20 and S20, M30 and S30, M40 and S40), one of the electrical connectors of each pair being mounted on the module and the other of the electrical connectors of each pair being mounted on the support, one of the electrical connectors of each pair (S10, S20, S30, S40) being mounted by mounting means leaving the connector suspended in the plane perpendicular to the relative movement by which the module and the base are brought closer together, each module comprising a circuit (M01) for heat exchange fluid, the said circuit having an inlet and an outlet for the heat exchange fluid, the support comprising, for each module, at least one intake opening for supplying heat exchange fluid to the said at least one module and at least one collecting opening for collecting the heat exchange fluid, each module comprising at least two hydraulic couplings (M011 and M012) to ensure that the circuit is coupled to the openings, the support comprising an inlet pipe forming a common inlet pipe (S11) for all the bases and comprising at least one hydraulic coupling (S011) per base, and an outlet pipe forming a common outlet pipe (S12) for all the bases and comprising at least one hydraulic coupling (S012) per base such that the electronic module or modules (M1, M2, M3, M4) are arranged to be supplied with heat exchange fluid in parallel.

2. Assembly according to Claim 1, in which the said couplings are self-closing and arranged such that they may be coupled simply by the relative movement bringing the module and the support closer to each other.

3. Assembly according to Claim 1 or 2, in which the support comprises a one-piece mechanical supporting structure, the said pipes being integrated within the said supporting structure.

4. Assembly according to one of Claims 1 to 3, in which the support comprises a one-piece mechanical supporting structure, the mechanical supporting structure comprising tubes which are substantially parallel (S1, S2) and each forming one of the common pipes, the tubes being connected mechanically and without any hydraulic communication from one tube to the next by spacers (S3), at least two ducts (S112 and S122) per base each being connected as a branch pipe to a different tube, each duct ending in one of the hydraulic couplings.

5. Assembly according to one of Claims 1 to 4, in which the support comprises at least one finger (S4) per base, the said at least one finger per base being mechanically connected without any hydraulic communication to one or other of the tubes or to both of them.

6. Assembly according to Claim 5, in which the one-piece mechanical supporting structure has at least one foot (S5) for fixing.

7. Assembly according to one of Claims 1 to 6, in which each of the pipes comprises an opening (S111, S121) intended to be coupled to an external installation in which the heat exchange fluid circulates.

8. Assembly according to one of Claims 1 to 7, comprising a mechanism for locking a module to the support.

9. Assembly according to Claim 8, comprising a mechanism (S7) for bringing the module and the support closer to each other.

10. Assembly according to one of Claims 1 to 9, in which the support comprises at least one socket (S9) for receiving an electrical connector.

11. Assembly according to any one of Claims 1 to 10, forming equipment for an automotive vehicle.

12. Assembly according to any one of Claims 1 to 11, in which the said module comprises electronic power components.

13. Assembly according to any one of Claims 1 to 12, in which the said module comprises an inverter intended to control an electric traction motor.

14. Support (S) forming a plurality of bases (B1, B2, B3, B4), each intended to receive an electronic module, the support comprising a plurality of sockets (S9) for each receiving at least one electrical connector (S10, S20, S30, S40) intended to ensure an electrical connection with one of the modules, the said socket defining a mounting plane for each electrical connector, at least one electrical connector (S10, S20, S30, S40) being mounted by mounting means leaving the connector suspended in the plane of the base, the support comprising at least one intake opening for supplying heat exchange fluid to the said modules and at least one collecting opening for collecting the heat exchange fluid, the support comprising an inlet pipe forming a common inlet pipe (S11) for all the bases, and comprising an outlet pipe forming a common outlet pipe (S12) for all the bases, the support comprising at least one hydraulic coupling (S011, S012) on each of the openings, each of the hydraulic couplings being arranged such that the hydraulic coupling is made in a direction substantially perpendicular to the said plane of mounting, such that the electronic module or modules (M1, M2, M3, M4) may be supplied with heat exchange fluid in parallel.

15. Support according to Claim 14, in which the said coupling is self-closing.

16. Support according to Claim 14 or 15, having a one-piece mechanical supporting structure, the said pipes being integrated within the said supporting structure.

17. Support according to Claim 16, having a one-piece mechanical supporting structure, the mechanical supporting structure comprising tubes which are substantially parallel and each forming one of the common pipes, the tubes being connected mechanically and without any hydraulic communication from one tube to the next by spacers, at least two ducts per base each being connected as a branch pipe to a different tube, each duct ending in one of the hydraulic couplings.

18. Support according to one of Claims 14 to 17, comprising at least one finger per base, the said at least one finger per base being mechanically connected without any hydraulic communication to one or other of the tubes or to both of them.

19. Support according to Claim 16, in which the one-piece mechanical supporting structure has at least three feet for fixing.

20. Support according to one of Claims 14 to 19, in which each of the pipes comprises an opening (S111, S121) intended to be coupled to an external installation in which the heat exchange fluid circulates.

21. Support according to one of Claims 14 to 20, comprising a mechanism for locking a module to the support.

22. Support according to Claim 21, comprising a mechanism for bringing the module and the support closer to each other.

## Patentansprüche

1. Einheit, die von mehreren elektronischen Modulen (M1, M2, M3, M4) und einem Gestell (S) gebildet wird, das mehrere Unterbauten aufweist, die je ein elektronisches Modul aufnehmen können, um die Module auf dem Gestell zu positionieren und elektrische Verbindungen aufzubauen, die zwischen mindestens einem Paar von elektrischen Verbindern (M10 und S10, M20 und S20, M30 und S30, M40 und S40) notwendig sind, wobei einer der elektrischen Verbinder jedes Paars auf das Modul und der andere der elektrischen Verbinder jedes Paars auf das Gestell montiert ist, wobei einer der elektrischen Verbinder jedes Paars (S10, S20, S30, S40) durch Montagemittel montiert ist, die den Verbinder in der Ebene lotrecht zur relativen Annäherungsbewegung zwischen Modul und Unterbau schwebend lassen, wobei jedes Modul einen Kreislauf (M01) für ein Wärmeträgerfluid aufweist, wobei der Kreislauf einen Eingang und einen Ausgang für das Wärmeträgerfluid hat, wobei das Gestell pro Modul mindestens eine Zufuhröffnung, um das mindestens eine Modul mit Wärmeträgerfluid zu speisen, und mindestens eine Sammelöffnung aufweist, um das Wärmeträgerfluid aufzufangen, wobei jedes Modul mindestens zwei hydraulische Anschlüsse (M011 und M012) aufweist, um den Anschluss des Kreislaufs an die Öffnungen zu gewährleisten, wobei das Gestell ein Eingangsrohr, das ein gemeinsames Eingangs-Verteilerrohr (S11) für alle Unterbauten bildet und mindestens einen hydraulischen Anschluss (S011) pro Unterbau aufweist, und ein Ausgangsrohr aufweist, das ein gemeinsames Ausgangs-Verteilerrohr (S12) für alle Unterbauten bildet und mindestens einen hydraulischen Anschluss (S012) pro Unterbau aufweist, so dass das oder die elektronische(n) Modul(e) (M1, M2, M3, M4) eingerichtet sind, um parallel mit Wärmeträgerfluid gespeist zu werden.

2. Einheit nach Anspruch 1, bei der die Anschlüsse selbstverschließend und so eingerichtet sind, dass sie nur durch die relative Annäherungsbewegung zwischen Modul und Gestell gekoppelt werden können.

3. Einheit nach Anspruch 1 oder 2, bei der das Gestell eine einstückige mechanische Trägerstruktur aufweist, wobei die Verteilerrohre in diese Trägerstruktur integriert sind.

4. Einheit nach einem der Ansprüche 1 bis 3, bei der das Gestell eine einstückige mechanische Trägerstruktur aufweist, wobei die mechanische Trägerstruktur im Wesentlichen parallele Rohre (S1, S2) aufweist, die je eines der gemeinsamen Verteilerrohre bilden, wobei die Rohre mechanisch und ohne hydraulische Verbindung von einem Rohr zum anderen durch Stege (S3) verbunden sind, wobei mindestens zwei Rohrleitungen (S112 und S122) pro Unterbau abgezweigt je an ein anderes Rohr angeschlossen sind, wobei jede Rohrleitung an einem der hydraulischen Anschlüsse mündet.

5. Einheit nach einem der Ansprüche 1 bis 4, bei der das Gestell mindestens eine Lasche (S4) pro Unterbau aufweist, wobei die mindestens eine Lasche pro Unterbau mechanisch und ohne hydraulische Verbindung mit dem einen oder dem anderen Rohr oder mit beiden verbunden ist.

6. Einheit nach Anspruch 5, bei der die einstückige mechanische Trägerstruktur mindestens einen Befestigungsfuß (S5) aufweist.

7. Einheit nach einem der Ansprüche 1 bis 6, bei der jedes der Verteilerrohre eine Öffnung (S111, S121) aufweist, die dazu bestimmt ist, an eine externe Einrichtung angeschlossen zu werden, in der das Wärmeträgerfluid fließt.

8. Einheit nach einem der Ansprüche 1 bis 7, die einen Verriegelungsmechanismus eines Moduls auf dem Gestell aufweist.

9. Einheit nach Anspruch 8, die einen Mechanismus der relativen Annäherung (S7) vom Modul zum Gestell aufweist.

10. Einheit nach einem der Ansprüche 1 bis 9, bei der das Gestell mindestens einen Sockel (S9) aufweist, um einen elektrischen Verbinder aufzunehmen.

11. Einheit nach einem der Ansprüche 1 bis 10, die ein Bauelement für ein Kraftfahrzeug bildet.

12. Einheit nach einem der Ansprüche 1 bis 11, bei der das Modul elektronische Leistungsbauteile aufweist.

13. Einheit nach einem der Ansprüche 1 bis 12, bei der das Modul einen Wechselrichter aufweist, der dazu bestimmt ist, einen elektrischen Fahrmotor zu steuern.

14. Gestell (S), das mehrere Unterbauten (B1, B2, B3, B4) bildet, die dazu bestimmt sind, je ein elektronisches Modul aufzunehmen, wobei das Gestell mehrere Sockel (S9) aufweist, um je mindestens einen elektrischen Verbinder (S10, S20, S30, S40) aufzunehmen, der dazu bestimmt ist, eine elektrische Verbindung mit einem der Module zu gewährleisten, wobei der Sockel eine Montageebene für jeden elektrischen Verbinder definiert, wobei mindestens ein elektrischer Verbinder (S10, S20, S30, S40) durch Montagemittel montiert wird, die den Verbinder in der Ebene des Unterbaus schwebend lassen, wobei das Gestell mindestens eine Zufuhröffnung, um die Module mit Wärmeträgerfluid zu speisen, und mindestens eine Sammelöffnung aufweist, um das Wärmeträgerfluid aufzufangen, wobei das Gestell ein Eingangs-Verteilerrohr, das ein gemeinsames Eingangs-Verteilerrohr (S11) für alle Unterbauten bildet, und ein Ausgangs-Verteilerrohr aufweist, das ein gemeinsames Ausgangs-Verteilerrohr (S12) für alle Unterbauten bildet, wobei das Gestell mindestens einen hydraulischen Anschluss (S011, S012) an jeder der Öffnungen aufweist, wobei jeder der hydraulischen Anschlüsse so eingerichtet ist, dass der hydraulische Anschluss in einer Richtung im Wesentlichen lotrecht zur Montageebene erfolgt, so dass das oder die elektronische(n) Modul(e) (M1, M2, M3, M4) parallel mit Wärmeträgerfluid gespeist werden können.

15. Gestell nach Anspruch 14, bei dem der Anschluss selbstverschließend ist.

16. Gestell nach Anspruch 14 oder 15, das eine einstückige mechanische Trägerstruktur aufweist, wobei die Verteilerrohre in die Trägerstruktur integriert sind.

17. Gestell nach Anspruch 16, das eine einstückige mechanische Trägerstruktur aufweist, wobei die mechanische Trägerstruktur im Wesentlichen parallele Rohre aufweist, die je eines der gemeinsamen Verteilerrohre bilden, wobei die Rohre mechanisch und ohne hydraulische Verbindung von einem Rohr zum anderen durch Stege verbunden sind, wobei mindestens zwei Rohrleitungen pro Unterbau abgezweigt je an ein anderes Rohr angeschlossen sind, wobei jede Rohrleitung an einem der hydraulischen Anschlüsse mündet.

18. Gestell nach einem der Ansprüche 14 bis 17, das mindestens eine Lasche pro Unterbau aufweist, wobei die mindestens eine Lasche pro Unterbau mechanisch und ohne hydraulische Verbindung mit dem einen oder anderen der Rohre oder mit beiden verbunden ist.

19. Gestell nach Anspruch 16, bei dem die einstückige mechanische Trägerstruktur mindestens drei Befestigungsfüße aufweist.

20. Gestell nach einem der Ansprüche 14 bis 19, bei dem jedes der Verteilerrohre eine Öffnung (S111, S121) aufweist, die dazu bestimmt ist, an eine externe Einrichtung angeschlossen zu werden, in der das Wärmeträgerfluid fließt.

21. Gestell nach einem der Ansprüche 14 bis 20, das einen Verriegelungsmechanismus eines Moduls auf dem Gestell aufweist.

22. Gestell nach Anspruch 21, das einen Mechanismus der relativen Annäherung vom Modul zum Gestell aufweist.
